# EUROPEAN PATENT APPLICATION

(11) **EP 4 625 495 A1**
(43) Date of publication of application: **01.10.2025**
(21) Application number: 24167759.0
(22) Date of filing: 28.03.2024
(51) Int. Cl.: H01L 27/02, H01L 29/868, H01L 29/786, H01L 29/423, H01L 27/06, H01L 27/07, H01L 21/8238

(54) **A SEMICONDUCTOR DEVICE AND A METHOD FOR FORMING A SEMICONDUCTOR DEVICE**

(71) Applicant: Imec VZW, 3001 Leuven (BE)
(72) Inventor: CHEN, Shih-Hung, 3010 Kessel-Lo (BE); CHAN, Boon Teik, 3012 Wilsele (BE); HELLINGS, Geert, 1500 Halle (BE); HORIGUCHI, Naoto, 3000 Leuven (BE)
(74) Representative: Lind Edlund Kenamets Intellectual Property AB

(57) **Abstract**

In an aspect there is provided a semiconductor device comprising:
first and second parallel multilayered active regions, each comprising at least one lower semiconductor layer and at least one upper semiconductor layer stacked over the at least one lower semiconductor layer; and
a PIN diode structure comprising:
an epitaxial first lower semiconductor body arranged along a first portion of the first active region, at a level of the at least one lower semiconductor layer of the first active region, and an epitaxial second lower semiconductor body arranged along a second portion of the second active region directly opposite to the first portion, at a level of the at least one lower semiconductor layer of the second active region;
an epitaxial first upper semiconductor body arranged along the first portion, at a level of the at least one upper semiconductor layer of the first active region and spaced apart from the first lower semiconductor body, and an epitaxial second upper semiconductor body arranged along the second portion, at a level of the at least one upper semiconductor layer of the second active region and spaced apart from the second lower semiconductor body; and
an epitaxial intermediate semiconductor body arranged between the first and second active regions, in contact with the first and second lower and upper semiconductor bodies and connecting the first and second lower and upper semiconductor bodies,

wherein the lower and upper semiconductor bodies are doped to define relatively high-doped P-type and N-type diode body portions, respectively, of the PIN diode structure, and wherein the intermediate semiconductor body defines a relatively low-doped or intrinsic diode portion of the PIN diode structure.

## Description

### TECHNICAL FIELD

The present invention generally relates to a semiconductor device comprising a PIN diode structure, and methods for forming a semiconductor structure comprising a PIN diode structure.

### BACKGROUND

Integrated circuits (ICs) are susceptible to damage from electrostatic discharge (ESD) events. ESD events may cause immediate device failure or a shortened lifespan of the circuit life. Diodes are often used to form ESD protection circuits for protecting ICs from ESD damage.

The Complementary Field-Effect Transistor (CFET) is a transistor device having a complementary pair of FETs stacked on top of each other, e.g. an NMOS device stacked on top of a PMOS device, or vice versa. The CFET device allows a reduced footprint compared to a traditional side-by-side arrangement of a complementary transistor pair and further enables a reduced routing resource usage due to its two device levels. The CFET is hence an enabling technology for denser and more area-efficient circuits.

### SUMMARY

Due to the vertical separation of the P- and N-type diffusion regions in CFET devices, and due to well contacts typically being absent in the CFET device regions, conventional approaches for designing and integrating diodes for ESD protection can be incompatible with, or at least not be readily combined with, the CFET device structure or current approaches for CFET device integration.

Therefore, it is an object of the present invention to provide a semiconductor device comprising a diode structure which may be readily and efficiently combined with CFET devices. It is further an object to provide methods facilitating fabrication of such semiconductor devices. It is further an object to enable fabrication of such semiconductor devices with limited additional masks or process steps beyond those used in conventional CFET device integration approaches. Further and alternative objectives may be understood from the following.

According to a first aspect of the present invention, there is provided a semiconductor device comprising:
first and second parallel multilayered active regions, each comprising at least one lower semiconductor layer and at least one upper semiconductor layer stacked over the at least one lower semiconductor layer;
a PIN diode structure comprising:
   an epitaxial first lower semiconductor body arranged along a first portion of the first active region, at a level of the at least one lower semiconductor layer of the first active region, and an epitaxial second lower semiconductor body arranged along a second portion of the second active region directly opposite to the first portion, at a level of the at least one lower semiconductor layer of the second active region;
   an epitaxial first upper semiconductor body arranged along the first portion, at a level of the at least one upper semiconductor layer of the first active region and spaced apart from the first lower semiconductor body, and an epitaxial second upper semiconductor body arranged along the second portion, at a level of the at least one upper semiconductor layer of the second active region and spaced apart from the second lower semiconductor body; and
   an epitaxial intermediate semiconductor body arranged between the first and second active regions, in contact with the first and second lower and upper semiconductor bodies and connecting the first and second lower and upper semiconductor bodies,
   wherein the lower and upper semiconductor bodies are doped to define relatively high-doped P-type and N-type diode body portions, respectively, of the PIN diode structure, and wherein the intermediate semiconductor body defines a relatively low-doped or intrinsic diode portion of the PIN diode structure.

According to the first aspect, there is provided a semiconductor device comprising a vertically oriented PIN diode structure (hereinafter interchangeably "diode structure") which may be readily and efficiently combined with CFET devices. Since the lower semiconductor bodies are arranged at the levels of the lower semiconductor layers (which may be used as channel layers for bottom transistor devices of one or more CFET devices along the respective active region), and the upper semiconductor bodies are arranged at the levels of the upper semiconductor layers (which may be used as channel layers for top devices of CFET devices along the respective active region), the P- and N-type diode body portions of the diode structure may be accommodated in the two device levels of the CFET device structure.

Further, as the intermediate semiconductor body is arranged between the first and second active regions, in contact with respective surface portions, such as sidewall portions, of the first and second lower upper semiconductor bodies (i.e., the P- and N-type diode body portions), the low-doped or intrinsic diode portion may be provided with a dimension and doping level which may be precisely controlled, without being limited by the typically small vertical separation between the (top-most) lower semiconductor / channel layer and the (bottom-most) upper semiconductor / channel layer of the CFET device structure. Further, the entire surface area of the sidewall portions of the bottom and upper semiconductor bodies is available for defining the contact interface towards the low-doped or intrinsic diode portion.

These properties, in combination, facilitate realizing as diode structure that may be incorporated in a CFET device structure, and further facilitate precise control of the threshold voltage of the diode structure.

By the term "active region" is herein meant an elongated feature or pattern of semiconductor material comprising a number of source/drain (S/D) regions and channel regions alternating the S/D regions. The S/D regions may comprise semiconductor material bodies, e.g., epitaxially grown, doped with an n- or p-type dopant. In relation to a CFET structure, each S/D region may comprise a lower S/D body (e.g., for a bottom transistor device) and an upper S/D body (e.g., for a top device). The channel regions may comprise a channel structure of a stack of at least one lower semiconductor layer and at least one upper semiconductor layer, extending between and connecting the semiconductor material bodies of the surrounding S/D regions. The lower and upper semiconductor layers may be in the form of nanowires or nanosheets (e.g., to form a gate-all-around transistor).

The first and second portions of the first and second active regions may be respective "recessed portion". By the term "recessed portion" is here meant a recess or cut extending downwardly through the active regions, more specifically through the lower and upper semiconductor layers. As may be appreciated from the following, the recessed portions may be formed at the locations of the active regions where S/D regions of CFET devices typically are formed. Hence, in some embodiments, the term "S/D recess" may be used as a synonym to "recessed portion".

By the terms "relatively high-doped" and "relatively low-doped", as used with reference to the lower and upper semiconductor bodies and the intermediate semiconductor body, is here meant that the bodies are high-doped / low-doped relative each other. For instance, the lower semiconductor body may have a first doping level (e.g., of P-type or N-type), the upper semiconductor body may have a second doping level (e.g., of the opposite type to the lower semiconductor body), and the intermediate semiconductor body may have a third doping level which is lower than each of the first and second doping levels. The third doping level may in particular correspond to that of an intrinsic or undoped semiconductor.

Since the intermediate semiconductor body is arranged in contact with both the first and second lower and upper semiconductor bodies, the diode structure enables a flexible contacting scheme. In some embodiments, a first bottom diode contact contacting the first lower semiconductor body, and/or a second bottom contact contacting the second lower semiconductor body, and a first top diode contact contacting the first upper semiconductor body, and/or a second top diode contact contacting the second upper semiconductor body.

In some embodiments, the first lower semiconductor body is arranged in contact with the at least one lower semiconductor layer of the first active region, and the second lower semiconductor body is arranged in contact with the at least one lower semiconductor layer of the second active region; and the first upper semiconductor body is arranged in contact with the least one upper semiconductor layer of the first active region, and the second upper semiconductor body is arranged in contact with the least one upper semiconductor layer of the second active region.

The channel layers may hence remain and be connected to the PIN diode structure. This further provides the option to connect the diode structure to S/D regions of neighboring CFET structures along the respective active regions, where present.

Furthermore, during fabrication, the diode structure does not require any additional process steps for removing the channel layers.

In some embodiments, the semiconductor device further comprises a gate structure extending transverse to the first and second active regions and overlapping the first and second active regions adjacent the first and second portions, wherein the PIN diode structure is located adjacent the gate structure.

The diode structure may hence be arranged adjacent, and be aligned to, a gate structure of the semiconductor device. While the gate structure does not form part of the PIN diode structure, as such, the gate structure may be used as a gate for any CFET devices formed along any further active regions parallel to first and second active regions. Hence, the PIN diode structure may be arranged on a same side of the gate structure as S/D regions of CFET devices arranged along the gate structure. This may further facilitate combining the diode structure with a CFET device structure. The diode structure may in particular be arranged between two parallel gate structures overlapping the first and second active regions on opposite sides of the respective recessed portions.

In some embodiments, the semiconductor device further comprises:
a plurality of parallel multilayered active regions, each comprising at least one lower semiconductor layer and at least one upper semiconductor layer stacked over the at least one lower semiconductor layer;
a plurality of parallel gate structures extending transverse to the plurality of active regions and overlapping respective channel regions of the active regions;
a plurality of complementary field-effect transistor, CFET, devices, wherein each CFET device comprises a respective one of the channel regions, and wherein each CFET device comprises a bottom transistor device and a top transistor device stacked on top of the bottom transistor device;
wherein the first and second active regions are comprised in the plurality of active regions, and wherein the PIN diode structure is located adjacent one of the plurality of gate structures.

The diode structure may hence be incorporated into an array of CFET devices, with the associated benefits set out above.

According to a second aspect, there is provided a method comprising:
forming first and second parallel multilayered semiconductor fins on a substrate, each comprising at least one lower semiconductor layer and at least one upper semiconductor layer stacked over the at least one lower semiconductor layer;
recessing a first portion of the first fin to form a first recess in the first fin, and a second portion of the second fin to form a second recess in the second fin, wherein the first and second recesses are formed directly opposite each other;
forming a PIN diode structure by:
   epitaxially growing a first lower semiconductor body in the first recess, in contact with each lower semiconductor layer of the first fin, and a second lower semiconductor body in the second recess, in contact with each lower semiconductor layer of the second fin;
   epitaxially growing intermediate semiconductor body portions between the first and second fins, wherein the intermediate semiconductor body portions are grown from respective sidewall portions of the first and second lower semiconductor bodies such that the intermediate body portions merge between the first and second fins to define a common intermediate semiconductor body connecting the first and second lower semiconductor bodies and having a top surface protruding above a level of the first and second lower semiconductor bodies; and
   subsequently, epitaxially growing a first upper semiconductor body in the first recess, spaced apart from the first lower semiconductor body and in contact with each upper semiconductor layer of the first fin and the top surface of the intermediate semiconductor body, and a second upper semiconductor body in the second recess, spaced apart from the second lower semiconductor body and in contact with each upper semiconductor layer of the second fin and the top surface of the intermediate semiconductor body;
   wherein the lower and upper semiconductor bodies are doped to define relatively high-doped P-type and N-type diode body portions, respectively, of the PIN diode structure, and wherein the intermediate semiconductor body defines a relatively low-doped or intrinsic diode portion of the PIN diode structure.

According to a third aspect, there is provided a method for forming a semiconductor device, the method comprising:
forming first and second parallel multilayered semiconductor fins on a substrate, each comprising at least one lower semiconductor layer and at least one upper semiconductor layer stacked over the at least one lower semiconductor layer;
recessing a first portion of the first fin to form a first recess in the first fin, and a second portion of the second fin to form a second recess in the second fin, wherein the first and second recesses are formed directly opposite each other;
forming a PIN diode structure by:
   epitaxially growing a first lower semiconductor body in the first recess, in contact with each lower semiconductor layer of the first fin, and a second lower semiconductor body in the second recess, in contact with each lower semiconductor layer of the second fin;
   epitaxially growing a first upper semiconductor body in the first recess, spaced apart from the first lower semiconductor body and in contact with each upper semiconductor layer of the first fin, and a second upper semiconductor body in the second recess, spaced apart from the second lower semiconductor body and in contact with each upper semiconductor layer of the second fin; and
   subsequently, epitaxially growing intermediate semiconductor body portions between the first and second fins, wherein the intermediate semiconductor body portions are grown from respective sidewall portions of the first and second lower and upper semiconductor bodies such that the intermediate body portions merge between the first and second fins to define a common intermediate semiconductor body connecting the first and second lower and upper semiconductor bodies,
   wherein the lower and upper semiconductor bodies are doped to define relatively high-doped P-type and N-type diode body portions, respectively, of the PIN diode structure, and wherein the intermediate semiconductor body defines a relatively low-doped or intrinsic diode portion of the PIN diode structure.

The methods of the second and third aspects hence define mutually alternative approaches enabling fabrication of a PIN diode structure with the merits discussed in relation to the first aspects.

During fabrication, the provision of the intermediate semiconductor body specifically between the first and second fins, may obviate a need to perform etch back of the lower semiconductor bodies prior to forming the intermediate semiconductor body, as otherwise may be needed to adapt a height of the lower semiconductor body and the area of the contact interface between the lower and intermediate semiconductor bodies.

Furthermore, the provision of the intermediate semiconductor body facilitates a rational fabrication of the diode structure. This since, the intermediate semiconductor body may be epitaxially grown from two opposite sides to merge between the first and second active regions, hence reducing a time needed to complete the formation of the intermediate semiconductor body.

In some embodiments, the method further comprises:
forming a first bottom diode contact contacting the first lower semiconductor body, and/or a second bottom diode contact contacting the second lower semiconductor body; and
forming a first top diode contact contacting the first upper semiconductor body, and/or a second top diode contact contacting the second upper semiconductor body.

In some embodiments, the method further comprises:
forming a cover layer covering the first and second lower semiconductor bodies; and
forming a trench in the cover layer between the first and second portions of the first and second fins,
wherein the intermediate semiconductor body is grown in the trench.

The intermediate semiconductor body may hence be formed in an area selective manner within the confines of the trench.

In some embodiments, the cover layer is a dielectric layer. The cover layer may hence remain as interlayer dielectric (ILD) in the finished device.

In some embodiments of the second aspect, the cover layer is formed such that a top surface of the cover layer is located at a higher level than the first and second lower semiconductor bodies and at a lower level than each upper semiconductor layer, and wherein the trench is formed to expose the respective sidewall portions of the first and second lower semiconductor bodies.

Hence, the lower semiconductor bodies may be covered by the cover layer such that growth of the intermediate semiconductor body on top of the lower semiconductor bodies may be counteracted. Meanwhile, the trench allows the growth to proceed selectively from the exposed the respective sidewall portions of the first and second lower semiconductor bodies. The opposite sidewall portions, facing outwardly with respect to the trench, will typically be covered by the cover layer during the growth of the intermediate semiconductor body.

In some embodiments, the cover layer is further used as an epitaxy mask for the first and second lower semiconductor bodies while forming the first and second upper semiconductor bodies.

The upper semiconductor bodies may hence be formed in an area selective manner from exposed surface portions of the intermediate semiconductor portion and the upper semiconductor layers.

In some embodiments of the third aspect, the cover layer is formed to cover the first and second lower and upper semiconductor bodies, and the trench is formed to expose the respective sidewall portions of the first and second lower and upper semiconductor bodies.

The trench, and the intermediate semiconductor body, may hence be formed after forming the lower and upper semiconductor bodies (e.g., after the bottom and top S/D epitaxy of CFET devices, where present).

In some embodiments, the cover layer comprises a lower portion formed after forming the first and second lower semiconductor bodies and prior to forming the first and second upper semiconductor bodies, and an upper portion formed on top of the lower portion after forming the first and second upper semiconductor bodies to cover the same prior to forming the trench, the lower portion is formed such that its top surface is located at a higher level than the first and second lower semiconductor bodies and at a lower level than each upper semiconductor layer, and the lower portion is used as an epitaxy mask for the first and second lower semiconductor bodies while forming the first and second upper semiconductor bodies.

The cover layer may hence be sequentially formed, wherein the lower portion may serve as epitaxy mask during the epitaxy of the upper semiconductor bodies. This may contribute to a rational fabrication of the diode structure.

In some embodiments, the method comprises forming a plurality of parallel multilayered semiconductor fins on the substrate, each comprising at least one lower semiconductor layer and at least one upper semiconductor layer stacked over the at least one lower semiconductor layer, and wherein the method further comprises:
forming a plurality of complementary field-effect transistor, CFET, devices, wherein each CFET device is formed along a fin of the plurality of fins, and each CFET device comprises a bottom transistor device and a top transistor device stacked on top of the bottom transistor device, wherein forming the plurality of CFET devices comprises:
forming a plurality of gate structures extending transverse to the plurality of fins and overlapping respective channel regions of the fins;
recessing portions of the fins in source/drain regions on either side of the respective channel regions to form a plurality of recesses;
epitaxially growing lower semiconductor bodies in the recesses, in contact with each lower semiconductor layer of the respective fin, the lower semiconductor bodies defining bottom source/drain features of the respective bottom transistor devices of the CFET devices; and
epitaxially growing upper semiconductor bodies in the recesses, in contact with each upper semiconductor layer of the respective fin, the upper semiconductor bodies defining top source/drain features of the respective top transistor devices of the CFET devices;
wherein the first and second fins are comprised in the plurality of fins;
wherein the first and second recesses are formed simultaneous to the plurality of recesses, and
wherein the first and second lower semiconductor bodies of the PIN diode structure are formed simultaneous to the bottom source/drain features and the first and second upper semiconductor bodies of the PIN diode structure are formed simultaneous to the top source/drain features.

The PIN diode structure may hence be formed in a streamlined fashion in parallel to the CFET devices.

### BRIEF DESCRIPTION OF THE DRAWINGS

This and other aspects of the present invention will now be described in more detail, with reference to the appended drawings.
Fig. 1 is a schematic perspective view of a CFET device.
Fig. 2 is a schematic top-down view of a semiconductor device.
Fig. 3 is a schematic cross sectional view of a PIN diode structure.
Fig. 4 is a schematic cross sectional view of a variant of the PIN diode structure.
Fig. 5-6 depict different configurations of bottom diode contacts.
Fig. 7a-f show process steps of a method for forming a semiconductor device comprising the PIN diode structure of Fig. 3.
Fig. 8a-d show process steps of a method for forming a semiconductor device comprising the PIN diode structure of Fig. 4.

### DETAILED DESCRIPTION

Implementations and examples of semiconductor devices comprising a PIN diode structure, and methods for forming the same, will below be described with reference to the drawings.

The drawings are only schematic and the relative dimensions of illustrated elements, such as layers or other structures, may be exaggerated and not drawn to scale. Rather the dimensions may be adapted for illustrational clarity and to facilitate understanding. When present in the figures, the indicated axes X, Y and Z point in a first horizontal direction, a second horizontal, and a vertical direction, respectively.

As used herein, the term "horizontal" refers to a direction parallel to an in-plane direction of the semiconductor layers of the multi-layered fins or active regions. When a substrate is present, the term "horizontal" may equivalently be understood to refer to a direction parallel to the substrate of the device structure, i.e. parallel to a main surface (e.g., a frontside) of the substrate. The term "lateral" may be used interchangeably with the term "horizontal". The term "vertical" refers to a direction normal or transverse to an in-plane direction of the semiconductor layers (or equivalently, a direction normal or transverse to a substrate, where present), or equivalently the direction along which the layers of the layer stack are stacked. Accordingly, terms indicating relative vertical arrangement of elements, such as "top", "upper", "bottom", "lower" and the like, are to be understood in relation to the vertical direction.

It is to be noted that when an element (e.g. a layer or other structure) is referred to as being "on" another element, it can be directly on the other element or on one or more intermediate elements on the other element. Conversely, when an element is referred to as being "directly on" another element, there is no intermediate element and the element is thus formed in physical contact or abutment with the other element.

It is further to be noted that terms such as "first" and "second" etc. with reference to elements (e.g. layers or other structures) or, as the case may be, process steps are used herein only as labels to facilitate distinguishing between different elements, and need not necessarily imply that such elements or process steps are arranged or performed in that particular order, unless stated otherwise.

Unless stated otherwise, a process step described herein as being applied to a substrate or a device structure may be applied to the entire substrate or device structure, or to only a portion thereof. Moreover, a process step applied to a substrate, such as a depositing a layer on a substrate, or an element or structure arranged on a substrate, may imply that the process step is applied to, or the element or structure is arranged on, a bare substrate or to a substrate already provided with one or more layers or features.

As used herein, the term "CFET" device refers to a device comprising a lower FET device or bottom FET device of a first conductivity type and an upper FET device or top FET device of a second conductive type opposite the first conductivity type stacked on top of the bottom FET device, e.g. an NMOS top device stacked on top of a PMOS bottom device, or vice versa. For conciseness the bottom FET device and the top FET device may interchangeably be referred to as a lower/bottom device and an upper/top device, respectively. The bottom device defines a bottom level or bottom tier of the CFET device and the top device defines a top level or top tier of the CFET device. The bottom device may be a PMOS device and the top device may be an NMOS device, or vice versa.

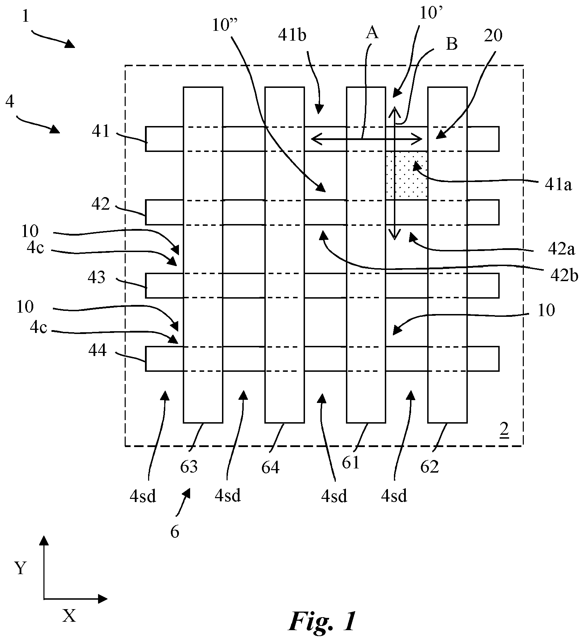

Fig. 1 is a schematic top-down view of a semiconductor device 1 comprising a substrate 2, a number of CFET devices 10 and a PIN diode structure 20.

The semiconductor device 1 comprises a substrate 2, a frontside of which is schematically indicated in Fig. 1. The substrate 2 may be of a conventional type suitable for CMOS devices, for instance a bulk substrate of a semiconductor such as Si or SiGe, or a silicon-on-insulator (SOI) substrate, a dielectric substrate, to give a few non-limiting examples.

The semiconductor device 1 further comprises a plurality of parallel active regions commonly designated 4. Fig. 1 shows by way of example four active regions 4, first and second active regions 41, 42 and two further active regions 43, 44. The active regions 4 extend in a first direction X along the substrate 2 and are spaced apart along a second direction Y along the substrate 2.

While Fig. 1 shows four active regions 4 and four gate structures 6, the semiconductor device 100 may in practice typically comprise a much larger number of active regions and gate structures.

Each active region 4 forms a multilayered elongated feature or pattern of semiconductor material, e.g., in the shape of a fin, comprising a number of S/D regions 4sd and channel regions 4c alternating the S/D regions 4sd.

The semiconductor device 1 further comprises a plurality of parallel gate structures commonly designated 6. Fig. 1 shows by way of example four gate structures 6, first and second gate structures 61, 62 and two further gate structures 63, 64. The gate structures 6 extend transverse to the plurality of active regions 4 along the second direction Y and overlap respective channel regions 4c of the active regions 4. The gate structures 6 are spaced apart along the first direction X.

A CFET device 10 may be arranged at each crossing between a gate structure 6 and an active region 4. To not overly obscure the drawing, CFET devices 10, S/D regions 4sd and channel regions 4c are indicated with reference signs at only a subset of the crossings between the active regions 4 and gate structures 6.

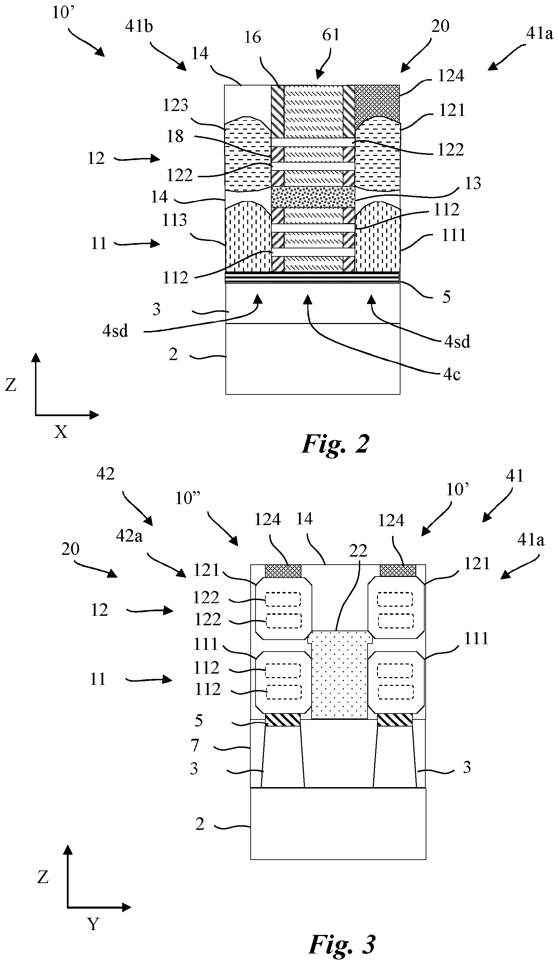

Fig. 2 shows a cross-section of a CFET device 10' of the semiconductor device 1, taken along line A indicated in Fig. 1. The CFET device 10' is hereinafter referred to as the "first" CFET device 10'. The first CFET device 10' is arranged at the crossing between the first gate structure 61 and the first active region 41. The cross-sectional view is generally representative for each of the further CFET devices 10 of the semiconductor device 100, including an adjacent second CFET device 10" arranged at the crossing between the first gate structure 61 and the second active region 42. Hence, the following description of the CFET device 10' applies correspondingly to any one of the CFET devices 10, 10".

The CFET device 10' comprises a bottom device 11 and a top device 12. The channel region 4c of the CFET device 10' (which is comprised in the first active region 41) comprises a number of lower semiconductor layers 112 and a number of upper semiconductor layers 122.

The lower semiconductor layers 112 define the channel structure of the bottom device 11. The upper semiconductor layers 122 define the channel structure of the top device 12. The lower and upper semiconductor layers 112, 122 form a stack of vertically spaced apart semiconductor layers. The illustrated example shows two lower semiconductor layers 112 and two upper semiconductors layers 122. This is however merely an example, and fewer or greater number of semiconductor layers are also possible. In any case, it is to be noted that each of the further channel regions 4c of the semiconductor device 100 shown in Fig. 1 may comprise a corresponding stack of lower and upper semiconductor layers.

The lower and upper semiconductor layers 112, 122 may comprise a semiconductor material such as a group IV semiconductor, e.g. Si, Ge, or SiGe.

The lower and upper semiconductor layers 112, 122 may be in the form of nanosheets. The CFET device 10' may hence comprise a bottom nanosheet FET (NSHFET) 10 and a top NSHFET 20. However, other configurations are also possible, such as a bottom NSHFET and a top FinFET, a bottom FinFET and a top NSHFET, and a bottom FinFET and a top FinFET.

The channel region 4c is overlapped by the first gate structure 61. In Fig. 2, the gate structure 61 is shown in a simplified and schematic fashion as a single material body. However, the gate structure 61 more specifically comprises a gate stack including a gate dielectric layer and one or more layers of a gate metal. The gate stack may comprise one or more gate metal layers, such as one or more work function metal (WFM) layers and/or a gate fill layer. Example WFMs include conventional n-type and p-type effect WFMs, such as TiN, TaN, TiAI, TiAIC or WCN, or combinations thereof. Example fill metals include W and Al. Example gate dielectrics include conventional gate dielectrics, e.g., a high-k dielectric such as HfO₂, LaO, AlO or ZrO.

The gate structure is configured to surround each lower and upper semiconductor layer 112, 122, at least partly (such as on three-sides) but typically completely to define a gate-all-around (GAA).

The lower and upper semiconductor layers 112, 122 may be separated by a middle dielectric layer 13 (e.g., of a nitride or oxide).

The CFET device 10' may have a split-gate configuration such that the gate structure 61 is partitioned into a bottom gate for the bottom device 11 and a top gate for the top device 12. However, a common gate configuration is also possible, wherein a common gate is shared by the bottom and top devices. That is, a CFET device with a common gate configuration comprises a common gate shared by the bottom and top channel structures.

A split gate configuration may for instance be obtained using the "sequential CFET process". As per se is known in the art, in the sequential CFET process the bottom and top devices are formed sequentially, and results in a split bottom and top gates. While the standard sequential CFET process results in a split gate configuration, it may be supplemented with additional process steps to open a bonding dielectric layer and form a gate merge via for interconnecting the bottom and top gates and thus define an electrically common gate for selected CFET devices.

A common gate configuration may for instance be obtained using the "monolithic CFET process". As per se is known in the art, in the monolithic CFET process the bottom and top devices are processed in parallel, top-down. While the standard monolithic CFET process results in a common gate configuration, it may be supplemented with additional process steps to enable a split gate configuration for selected CFET devices (e.g. bottom gate recess, bottom gate capping, followed by top gate formation).

The lower and upper semiconductor layers 112, 122 may as shown be arranged over a respective fin-shaped base portion 3 protruding from the substrate 2. The base portion 3 may be formed of a relatively low-doped or intrinsic semiconductor. The base portion 3 may be surrounded by shallow trench isolation regions 7 (visible in Fig. 3) on either lateral side. The base portion 3 may be separated from the bottom device 11 by a conventional bottom insulating layer 6 (e.g., an oxide or nitride layer) capping the base portion 3.

The S/D regions 4sd of the CFET device 1' are arranged on either side of the channel region 4c and the first gate structure 61.

The S/D regions 4sd are formed along or in respective recessed portions ("S/D recesses") 41a, 41b of the first active region 41. The recessed portion 41a may hereinafter be referred to as the "first" recessed portion or S/D recess 41a.

The S/D regions 4sd comprise epitaxial lower semiconductor bodies 111, 113 arranged in the S/D recesses 41a and 41b, respectively, and defining S/D features of the bottom device 11. The S/D regions 4sd further comprise epitaxial upper semiconductor bodies 121, 123 arranged in the S/D recesses 41a and 41b, respectively, and defining S/D features of the top device 12. The lower and upper semiconductor bodies 111, 121 may hereinafter be referred to as the "first" lower and upper semiconductor bodies 111, 121.

The lower semiconductor bodies 111, 113 are formed in contact with the lower semiconductor layers 112, and the upper semiconductor bodies 121, 123 are formed in contact with the upper semiconductor layers 122, more specifically with respective ends of the lower and upper semiconductor layers 113, 123 facing the S/D recesses 41a, 41b.

The lower semiconductor bodies 111, 113 and the upper semiconductor bodies 121, 123 may each be doped in accordance with the respective conductivity types of the bottom and top devices 11, 12.

The lower semiconductor bodies 111, 113 and the upper semiconductor bodies 121, 123 are covered by and embedded in a dielectric layer 14, further surrounding the gate structure 61 on either side. The dielectric layer 14 may be formed of one or more dielectric materials suitable as interlayer dielectric, such as one or more oxides and/or nitrides, typically of low-k.

In the illustrated example, the lower semiconductor bodies 111, 113 and the upper semiconductor bodies 121, 123 are vertically spaced apart so as to define separate S/D features for the bottom and top device 11, 12. The lower semiconductor bodies 111, 113 and the upper semiconductor bodies 121, 123 are separated by a lower thickness portion of the dielectric layer 14, covering the lower semiconductor bodies 111, 113.

The gate stack of the gate structure 61 may be separated from the S/D regions 4sd by a gate spacer 16 and inner spacers 18 (indicated by respective diagonal hatchings in Fig. 2).

The S/D regions 4sd of the CFET device 10' may further be provided with S/D contacts, as exemplified in Fig. 2 by the S/D contact 124 arranged in contact with the upper semiconductor body 121.

In general, a S/D contact may be provided in any one or both S/D regions of a CFET device, in contact with the S/D feature of the bottom and/or top device. The S/D features of the bottom and top devices may be contacted with separate S/D contacts or a common S/D contact. While this in principle is applicable to any of the CFET device 10 in Fig. 1, a specifically adapted S/D contact scheme will typically be provided for the lower and upper semiconductor bodies 111, 121 of the first CFET device 10', and the corresponding lower and upper semiconductor bodies 111, 121 of the second CFET device 10" (shown in Fig. 3), due to the presence of the PIN diode structure 20 further discussed below.

For sake of completeness, it is further noted that while the CFET device 10' comprises separate bottom and top S/D features in each S/D region 4sd, it is also possible to provide a CFET device with a merged bottom and top S/D feature. This may be achieved by growing the lower and upper semiconductor bodies such that they merge between the bottom and top device. However, due to the provision of the PIN diode structure 20, it is to be noted that a specifically adapted configuration applies to the lower and upper semiconductor bodies 111, 121 of the first and second CFET devices 10', 10", as set out below.

Fig. 3 shows a cross-section of the (PIN) diode structure 20, taken along line B indicated in Fig. 1. The diode structure 20 is located on the first side of the first gate structure 61. The cross-section of Fig. 3 extends through the first recessed portion or S/D recess 41a of the first active region 41, and the directly opposite recessed portion of S/D recess 42a of the second active region 42 (hereinafter "second" recessed portion or S/D recess 42a).

In Fig. 3, like elements along the first and second active regions 41, 42, and of the first and second CFET devices 10', 10" are indicated with like reference signs.

The lower and upper semiconductor bodies 111, 121 in the first S/D recess 41a and in the second S/D recess 42a will in the following be referred to as the "first" and "second" lower and upper semiconductor bodies, respectively.

The diode structure 20 further comprises an epitaxial intermediate semiconductor body 22 arranged between the first and second S/D recesses 41a, 42a. The intermediate semiconductor body 22 is arranged in contact with respective sidewall portions of the first and second lower and upper semiconductor bodies 111, 121 and interconnecting the same. The contact here refers to a direct contact so as to establish a direct physical and electrical interface (e.g., PI- and IN-junction, respectively) between the respective upper semiconductor bodies 121 and the intermediate semiconductor body 22, and the respective lower semiconductor bodies 111 and the intermediate semiconductor body 22.

The intermediate semiconductor body 22 may as shown be separated from the substrate 2 by a thickness portion of the shallow trench isolation region 7, where present between the first and second active regions 41, 42.

The lower and upper semiconductor bodies 111, 121 and the intermediate semiconductor body 22 may each be formed of Si and/or Ge comprising material, for instance of a similar composition as the lower and upper semiconductor layers 112, 122.

The lower and upper semiconductor bodies 111, 121 are configured as relatively high-doped P-type and N-type diode body portions, respectively, of the PIN diode structure 20. For instance, where the bottom devices 11 of the first and second CFET devices 10', 10" are NMOS devices and the top devices 12 are PMOS devices, the first and second lower semiconductor bodies 121 may define N-type diode portions of the diode structure 20 and the first and second upper semiconductor bodies may define P-type diode portions of the diode structure 20. Conversely, where the bottom devices 11 of the first and second CFET devices 10', 10" are PMOS devices and the top devices 12 are NMOS devices, the first and second lower semiconductor bodies 121 may define P-type diode portions of the diode structure 20 and the first and second upper semiconductor bodies may define N-type diode portions of the diode structure 20.

The intermediate semiconductor body 22 on the other hand defines a relatively low-doped or intrinsic diode portion of the PIN diode structure 20.

For instance, the lower semiconductor bodies 111 may be formed as P-type bodies (or N-type bodies) with a first doping level and the upper semiconductor bodies 121 may be formed as N-type bodies (or P-type bodies) with a second doping level. The intermediate semiconductor body 22 be formed as a semiconductor body with a third doping level which is lower than each of the first and second doping levels. The third doping level may in particular correspond to that of an intrinsic or undoped semiconductor. By way of example, the first and second doping levels may be above 1E18 cm⁻³ and the third doping level may be 1E18 cm⁻³ or lower, such as in a range from 2E16 to 1E18 cm⁻³.

As may be appreciated, the specific doping levels of the bodies 111, 121, 22 will in general vary to adapt the threshold voltage of the diode structure 20, e.g., depending on the ESD requirements of the particular implementation, the ability of the surrounding devices to withstand ESD discharges, drive currents and threshold voltages of the CFET devices, etc. This applies also to the area of the respective contact interfaces between the intermediate semiconductor body 22 and each of the lower and upper semiconductor bodies 111, 121.

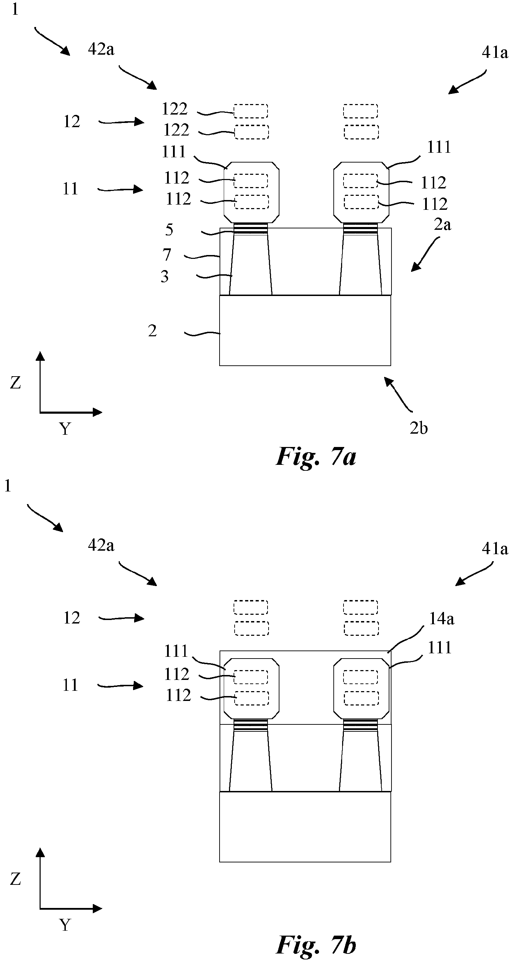

In Fig. 3, the top portion of the intermediate semiconductor body 22 has a wider footprint than its lower main portion. This particular shape may result if the intermediate semiconductor body 22 is grown to a height which is greater than the depth of a trench in which it is grown. A method for fabricating the semiconductor device 1 and the diode structure 20 will be described below with reference to Fig. 7a-f.

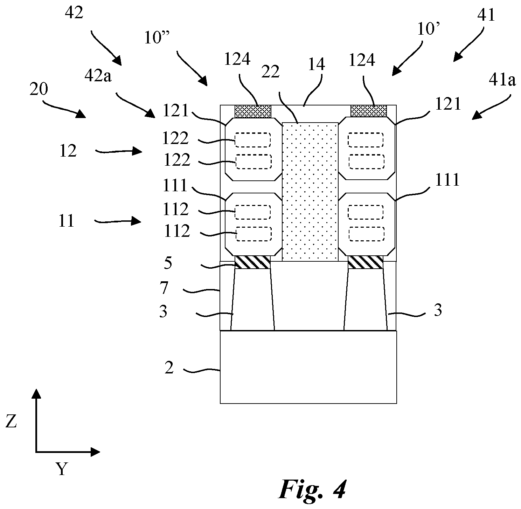

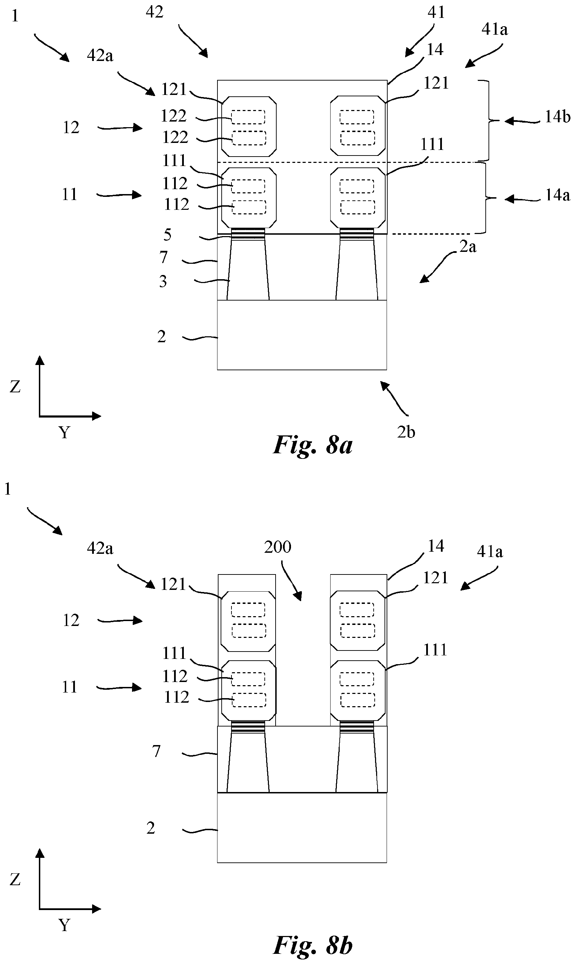

However, also other shapes of the intermediate semiconductor body 22 is possible. Fig. 4 shows a variant of the semiconductor device 1 wherein the diode structure 20 comprises a taller pillar shaped intermediate semiconductor body 22 with a substantially uniform footprint. This shape may enable a greater contact interface between the intermediate semiconductor body 22 and the upper semiconductor bodies 121. A method for fabricating thesemiconductor device 1 and the diode structure 20 will be described below with reference to Fig. 8a-d.

Since the intermediate semiconductor body 22 is arranged in contact with both the first and second lower and upper semiconductor bodies 111, 121, various contacting schemes for the diode structure 20 from the top and from the bottom are possible.

In Fig. 3 and 4, a S/D contact 124 defining a respective top diode contact is arranged on top of and in contact with the first and second upper semiconductor bodies 121. This may enable an enlarged contact interface towards the top part of the diode structure 20, and may also facilitate contacting the diode structure 20 from different lateral sides. However, it is also possible to form a top diode contact on only one of the upper semiconductor bodies 121.

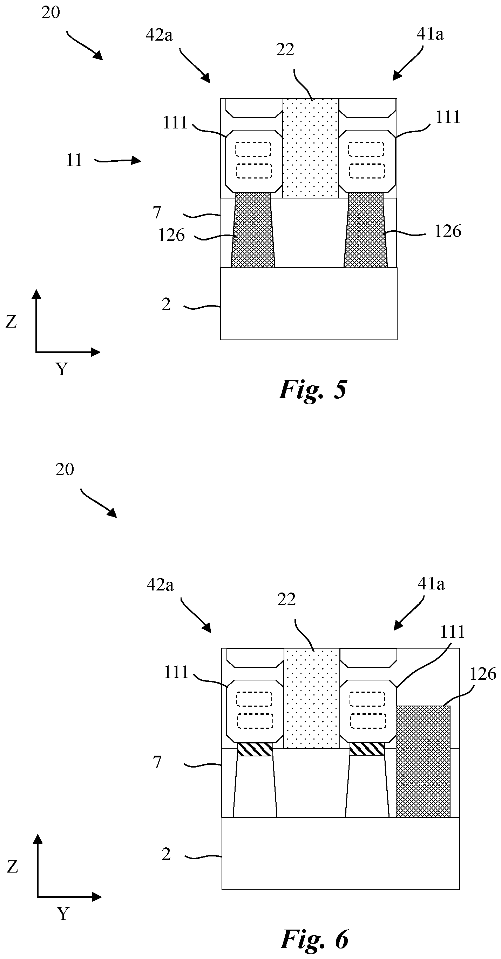

Fig. 5-6 show various configurations of bottom diode contacts. For illustrational clarity the upper portion of the diode structure 20 has been omitted from the figures.

In Fig. 5, a respective bottom diode contact 126 is arranged underneath and in contact with each of the first and second lower semiconductor bodies 111. A part of the base portion 3 underneath the respective lower semiconductor bodies 111 has thus been replaced with a contact material (e.g., any of the above-mentioned contact metals).

Analogous to the discussion of the top diode contacts 124, providing a bottom diode contact 126 in contact with each of the lower semiconductor bodies 111 may enable an enlarged contact interface towards the bottom part of the diode structure 20, and facilitate contacting the diode structure 20 from different lateral sides. However, it is also possible to form a bottom diode contact in contact with only one of the lower semiconductor bodies 111.

Fig. 6 shows a further configuration wherein a bottom diode contact 126 is arranged adjacent the diode structure 20, contacting the second lower semiconductor body 111 from the side, i.e., the sidewall portion opposite to the sidewall portion contacting the intermediate semiconductor body 22.

The bottom diode contact configurations in each of Fig. 5-6 may be combined with any of the above-mentioned top side contact configurations and shapes of intermediate semiconductor body 22.

For either of the top and bottom contact configurations shown in Fig. 2-6, the bottom and top diode contacts 124, 126 may further be connected to surrounding circuitry and conductive structures provided on a frontside and/or backside of the semiconductor device 1. For example, the top diode contact(s) 124 may be connected to a frontside interconnect structure arranged over the CFET devices 10, 10', 10". The bottom diode contact(s) 126 may be connected to a ground rail. The ground rail may for example be configured as a buried rail, encapsulated in the shallow trench isolation 7 and/or the substrate 2, or as a backside rail of a backside power distribution network, arranged on a backside of the semiconductor device 1. The connection between a bottom diode contact 126 and a backside rail may be realized by a via extending through the substrate 2.

As per se is known in the art, the substrate 2 may in some implementations serve as a substrate during fabrication of the active devices and subsequently be removed, partially or completely in the final device (e.g., by grinding and/or thinning). In the latter case, a bottom diode contact may be formed by a via of the backside power distribution network, extending between a ground rail and a lower semiconductor body 111.

In the illustrated example, the diode structure 20 is integrated with the S/D regions 4sd of a pair of first and second CFET devices 10', 10". This enables additional contacting approaches for the diode structure 20 in that bottom or top devices of the first and/or second CFET devices 10', 10" may be configured or used as terminals for the diode structure 20. E.g., by a suitable gate voltage applied to the gate structure 61 at either of the first and second CFET devices 10', 10", the respective bottom or top device may be switched on so as to provide an input for an ESD discharge current into the diode structure 20.

A first method for forming the semiconductor device 1 comprising the PIN diode structure 20 as shown in Fig. 3 will now be described with reference to Fig. 7a-f. Unless stated otherwise, like reference signs will refer to like elements and an undue repeated description of such elements will hence be omitted.

Fig. 7a schematically shows the semiconductor device 1 at an initial or starting stage for the method, to be subjected to the process steps disclosed in the following.

At the stage shown in Fig. 7a, multilayered fins have been formed on the substrate 2, separated by shallow trench isolation 7. With reference to Fig. 1, a plurality of fins for the plurality of active regions 4 may be formed in parallel. The fins may, in addition to lower and upper semiconductor layers for forming channel structures for the bottom and top devices of CFET devices, comprise sacrificial semiconductor layers separating the lower and upper semiconductor layers to facilitate a subsequent channel layer release, further described below.

Further, gate structures 6, including the first gate structure 61 (shown in Fig. 1 and 2) have been formed to extend across and overlap the active regions or fins in respective channel regions thereof. The first gate structure 61 is not visible in the cross-section of Fig. 7a as it is located behind the drawing plane. It is noted that the gate structures may at this stage be sacrificial gate structures (e.g., of a-Si or another sacrificial gate material), to be replaced by functional or metal gate stacks in the final device.

Fin patterning, techniques for forming shallow trench isolation, and gate patterning is per se well known in the art and will not be further described herein.

Further, the first and second lower semiconductor bodies 111 have been epitaxially grown in respective S/D recesses 41a, 42a along the first and second active regions or fins 41, 42. It is noted that the epitaxy of the lower semiconductor bodies 111 may be conducted as part of the bottom S/D epitaxy to form the S/D features for the bottom devices of the CFET devices 10, 10', 10" which are to be formed (see. Fig. 1).

The S/D recesses 41a, 42a may be formed by etching back (i.e., recessing) the first and second fins 41, 42 on either side of the first gate structure 61. With reference to Fig. 1, this may be performed in parallel for each S/D region 4sd of each fin / active region 4. The recessing of the fins 41, 42 defines ends of the lower and upper semiconductor layers 112, 122, facing the respective S/D recesses.

The method may then proceed with conducting S/D epitaxy to form the lower semiconductor bodies 111 in contact with the ends of the lower semiconductor layers 112 facing the S/D recesses 41a, 42b. The epitaxy may be performed using conventional deposition techniques such as chemical vapor deposition (CVD) or physical vapor deposition (PVD). The epitaxially grown material of the lower semiconductor bodies 111, as well as of the further S/D regions of the semiconductor device 1, may be in-situ doped to define respective doped epitaxial semiconductor bodies of a desired conductivity type and doping level.

The S/D epitaxy may further typically be preceded by process steps for forming inner spacers at the levels of the sacrificial semiconductor layers, using techniques which per se are known in the art.

While forming the lower semiconductor bodies 111, the ends of the upper semiconductor layers 122 may be masked by a temporary cover spacer, e.g., formed using a conformal deposition process such as atomic layer deposition (ALD).

In Fig. 7b, a cover layer 14a has been formed to cover the first and second lower semiconductor bodies 111. The cover layer 14a corresponds to a lower thickness portion of the cover layer 14 in Fig. 3 and may accordingly be a dielectric layer. The cover layer 14a may be formed by depositing a dielectric material (e.g., an oxide such as silicon oxide or another material suitable as interlayer dielectric) using a conventional deposition process such as CVD, or Flowable CVD (FCVD). The deposited dielectric material may be recessed (e.g., etched back) to a level above the lower semiconductor bodies 111 and below the upper semiconductor layers 122, as shown in Fig. 7b.

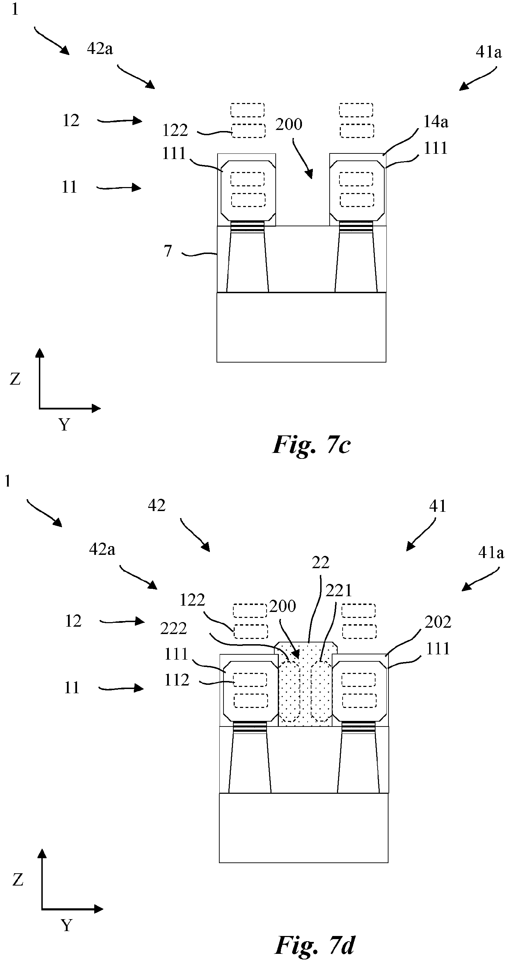

In Fig. 7c, a trench 200 has been formed in the cover layer 14a, between the first and second S/D recesses 41a, 42a, and between the first and second lower semiconductor bodies 111 therein. The trench 200 is formed to expose respective sidewall portions of the first and second lower semiconductor bodies 111.

The trench 200 may be formed by lithography and etching. It is noted that the trench 200 will be selectively formed at the locations where the PIN diode structure 20 is to be formed. Hence, locations of the semiconductor device 1 where no PIN diode structure is desired will be substantially unaffected by this process step.

The etching of the trench 200 may as shown be stopped on the shallow trench isolation. However, it is also possible to form the trench 200 such that it extends into an upper thickness portion of the shallow trench isolation, or forming the trench 200 with a smaller depth such that a thickness portion of the cover layer 14a is preserved underneath the trench 200.

In Fig. 7d, an intermediate semiconductor body 22 has been formed in the trench 200, between the S/D recesses 41a, 42a, and in contact with the respective sidewall portions of the first and second lower semiconductor bodies 111.

As schematically indicated by the intermediate body portions 221, 222 (dashed outlines) within the intermediate semiconductor body 22, the semiconductor material of the intermediate semiconductor body 22 may grow laterally from the respective sidewall portions of the first and second lower semiconductor bodies 111. The epitaxy may proceed such that the intermediate body portions 221, 222 merge between the lower semiconductor bodies 111 to define a common intermediate semiconductor body 22. The epitaxy may be stopped once the intermediate semiconductor body 22 has obtained a desired height, typically such that its top surface protrudes above a level of the lower semiconductor bodies 111.

If the epitaxy is conducted such that the intermediate semiconductor body 22 grows outside the trench 200, the top portion of the intermediate semiconductor body 22 may be formed with an enlarged footprint, as schematically indicated by the mushroom shaped intermediate semiconductor body 22 in Fig. 7d.

As discussed above, the intermediate semiconductor body 22 is to be formed as a relatively low-doped or intrinsic diode portion of the PIN diode structure 20. Accordingly, the epitaxy of the intermediate semiconductor body 22 may be conducted without any in-situ doping. In case doping is applied, the doping may be adapted to form the intermediate semiconductor body 22 with a doping level such that it may define the I-portion of the diode structure 20. It is further contemplated that the intermediate semiconductor body 22 may be formed with a variable doping profile along its thickness dimension, e.g., such that the doping level gradually reduces in a bottom-to-top direction to an intrinsic level.

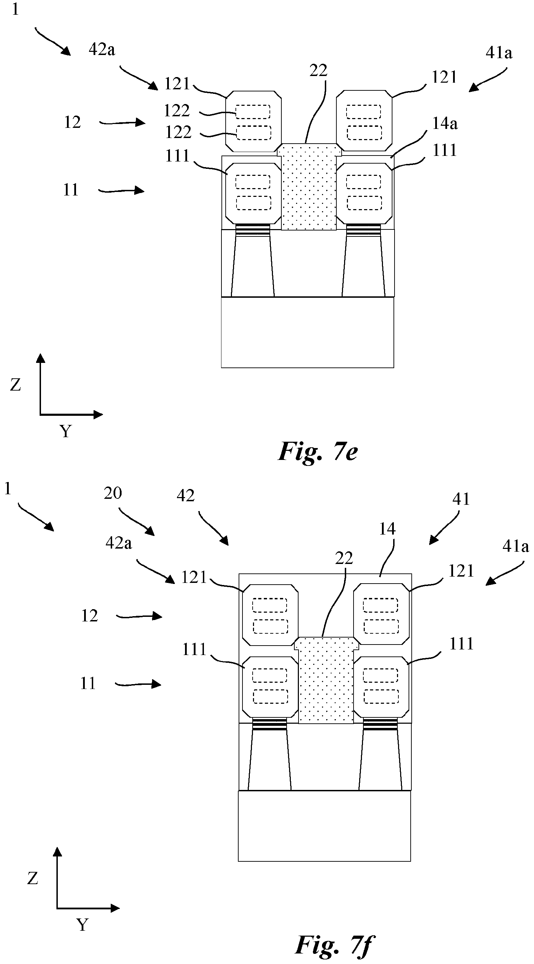

In Fig. 7e, the first and second upper semiconductor bodies 121 have been epitaxially grown in the respective S/D recesses 41a, 42a. It is noted that the epitaxy of the upper semiconductor bodies 121 may be conducted as part of the top S/D epitaxy to form the S/D features for the top devices of the CFET devices 10, 10', 10" which are to be formed (see. Fig. 1).

Prior to conducting the top S/D epitaxy, the cover spacer, where present, may be removed to reveal the ends of the upper semiconductor layers 122 facing the S/D recesses 41a, 42a.

The upper semiconductor bodies 121 may be formed in a corresponding manner to the lower semiconductor bodies 111, e.g., using CVD or PVD, and in-situ doping.

Due to the presence of the (dielectric) cover layer 14a, the lower semiconductor bodies 111 and the upper semiconductor bodies 121 are vertically separated by a thickness portion of the cover layer 14a. The cover layer 14a may hence be used as an epitaxy mask while forming the upper semiconductor bodies 121. The upper semiconductor bodies 121 are hence formed in contact only with the top portion of the intermediate semiconductor body 22 exposed in the cover layer 14a, and the ends of the upper semiconductor layers 121.

While not expressly shown in Fig. 7e, the epitaxial process may further result in some growth of upper semiconductor body material also on the top surface of the intermediate semiconductor body 22. However, since the top surface of the intermediate semiconductor body 22 and the ends of the upper semiconductor layers 122 have different lattice orientations, and further may be formed of different materials (e.g., different Si and Ge content), it is possible to adapt the epitaxial process such that there is less growth from the top portion of the intermediate semiconductor body 22. However, growth of the upper semiconductor bodies 121 from both the upper semiconductor layers 122 and the intermediate semiconductor body 22 is not something which per se must be avoided, but may in some situations be acceptable or even promoted, e.g., to grow the upper semiconductor bodies 121 more quickly, or to facilitate forming a top diode portion with a greater volume.

In Fig. 7f, the resulting PIN diode structure 20 formed by the lower semiconductor bodies 111, the intermediate semiconductor body 20, and the upper semiconductor bodies 121 have been covered by further dielectric material to form a final embedding cover layer 14.

The method may thereafter proceed with forming top and bottom diode contacts, as shown and discussed in connection with Fig. 3-6. For instance, one or more top contacts 124 may be formed by opening the cover layer 14 to reveal one or both upper semiconductor bodies 121 and then depositing contact metal thereon. One or more bottom contacts 126 may be formed by processing the substrate 2 from the backside, to access the base portions 7 underneath one or both lower semiconductor bodies 111, and replacing the base portion 7 with contact metal. A bottom diode contact 126 as shown in Fig. 6 may be formed by etching a contact trench in the cover layer 14 and the shallow trench isolation 7, and filling the contact trench with contact metal.

Furthermore, the method may proceed with remaining steps for forming the CFET devices 10, 10', 10", such as removing the sacrificial gates to define gate trenches exposing the lower and upper semiconductor layers 112, 122 and any sacrificial layers along the channel regions 4c, removing the sacrificial layer to release the lower and upper semiconductor layers 112, 122, and depositing a gate stack in the gate trenches. These steps are per se conventional for CFET device processing and will hence not be further discussed herein.

A second method for forming the semiconductor device 1 comprising the PIN diode structure 20 as shown in Fig. 4 will now be described with reference to Fig. 8a-d. Unless stated otherwise, like reference signs will refer to like elements and an undue repeated description of such elements will hence be omitted.

Fig. 8a schematically shows the semiconductor device 1 at an initial or starting stage for the method, to be subjected to the process steps disclosed in the following.

The description of the semiconductor device 1 as shown in connection with Fig. 7a, generally corresponds to stage of the semiconductor device 1 shown in Fig. 8a, however differs that in addition to the lower semiconductor bodies 111, also the upper semiconductor bodies 121 have been formed. The lower and upper semiconductor bodies 111, 121 have subsequently been covered with a (dielectric) cover layer 14.

As discussed above, a temporary cover spacer may be formed to mask the ends of the upper semiconductor layers 122 while forming the lower semiconductor bodies 111. The cover spacer may be removed prior to initiating the epitaxy of the upper semiconductor bodies 121.

The cover layer 14 may here, like the cover layer 14 in Fig. 7f, be formed in two steps and accordingly comprise a lower portion 14a, formed after forming the lower semiconductor bodies 111 and prior to forming the upper semiconductor bodies 121, and an upper portion 14b formed on top of the lower portion 14a after forming the upper semiconductor bodies 121 to cover the same.

The lower portion 14a may be formed such that its top surface is located at a higher level than the lower semiconductor bodies 111 and at a lower level than each upper semiconductor layer 122. The lower portion 14a may accordingly be used as an epitaxy mask for the lower semiconductor bodies 111 while forming the first and second upper semiconductor bodies 121.

In Fig. 8b, a trench 200 has been formed in the cover layer 14. The trench 200 is formed to expose the respective sidewall portions of the first and second lower and upper semiconductor bodies 111, 121. The trench 200 may otherwise be formed in an analogous manner to the trench 200 in Fig. 7c.

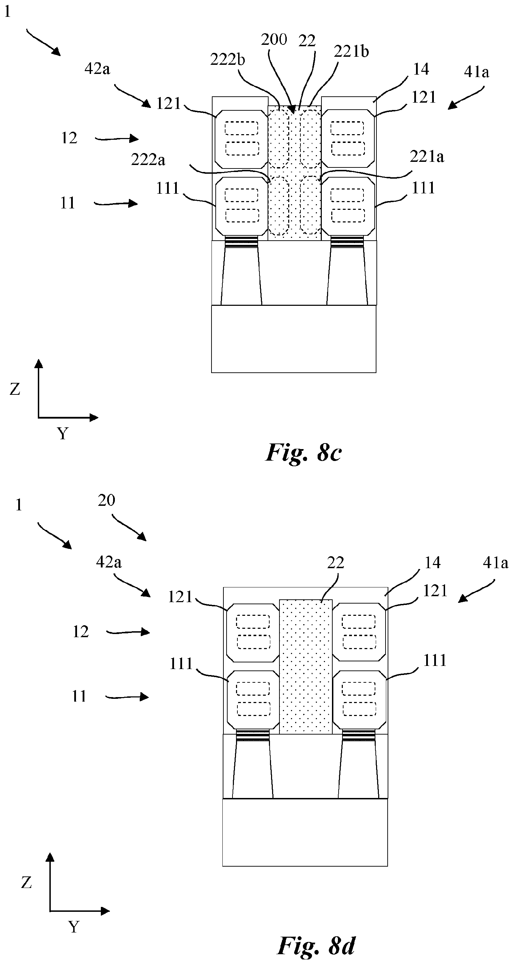

In Fig. 8c, an intermediate semiconductor body 22 connecting the first and second lower and upper semiconductor bodies 111, 121, has been formed in the trench 200.

The intermediate semiconductor body 22 is formed between the S/D recesses 41a, 42a, and in contact with the respective sidewall portions of the lower and upper semiconductor bodies 111, 121.

As schematically indicated by the intermediate body portions 221a, 221b, 222a, 222b, (dashed outlines) within the intermediate semiconductor body 22, the semiconductor material of the intermediate semiconductor body 22 may grow laterally from the respective sidewall portions of the lower and upper semiconductor bodies 111, 121 exposed in the trench 200. The epitaxy may proceed such that the intermediate body portions 221a, 221b, 222a, 222b merge between the semiconductor bodies 111, 121 to define a common intermediate semiconductor body 22. The epitaxy may be stopped once the intermediate semiconductor body 22 has obtained a desired height, typically while its top surface still is within the trench 200.

In Fig. 8d, the trench 200 has been re-filled with dielectric to cover the diode structure 20, including the intermediate semiconductor body 22, by the cover layer 14.

The method may then proceed with diode contact formation and CFET device fabrication, as set out above.

The person skilled in the art realizes that the present invention by no means is limited to the examples described above. On the contrary, many modifications and variations are possible within the scope of the appended claims.

For example, while in the above methods, the cover layer 14a and 14 is a dielectric layer, intended to be preserved as interlayer dielectric in the final device, it is also possible to form the cover layer 14a and 14 as a dummy cover layer of a dummy material (e.g., an organic spin-on material such as spin-on-carbon). The dummy material may then be removed and replaced with an interlayer dielectric material after completing the S/D epitaxy, such as prior to forming diode and S/D contacts.

Furthermore, in the illustrated example of Fig. 1, the semiconductor device 1 comprises a single diode structure 20. However, it is to be noted that a plurality of corresponding PIN diode structures 20 may be arranged at a crossing between any one of the active regions 4 and the gate structures 6.

Additionally, in the above, the diode structure 20 is, in part, formed by lower and upper semiconductor bodies 111, 121 of S/D regions 4sd of a pair of CFET devices 10', 10". However, it is contemplated that in some implementations the channel structures of the CFET device 10', 10", and/or the parts of the gate structure 61 defining the gates of the CFET devices 10', 10" may be removed before completing the semiconductor device 1. For instance, the channel structures of the CFET devices 10', 10" and/or parts of the gate structure 61 may be removed by etching after forming after forming the lower and upper semiconductor bodies 111, 121 of the diode structure 20. While this entails additional process steps, and may increase the complexity of the fabrication, this could in some instances be useful if there is a risk for undesired leakage paths or parasitic couplings to the diode structure 20 through the channel structures of the CFET devices 10', 10". In such a case, there may be no lower and upper semiconductor layers in direct contact with the lower and upper semiconductor bodies 111, 121. However, the lower and upper semiconductor bodies 111, 121 may still be arranged at a same respective level as lower and upper semiconductor layers of remaining CFET devices 10 along the respective active regions 41, 42.

## Claims

1. A semiconductor device (1) comprising:
first and second parallel multilayered active regions (41, 42), each comprising at least one lower semiconductor layer (112) and at least one upper semiconductor layer (122) stacked over the at least one lower semiconductor layer (112);
a PIN diode structure (20) comprising:
an epitaxial first lower semiconductor body (111) arranged along a first portion (41a) of the first active region (41), at a level of the at least one lower semiconductor layer (112) of the first active region (41), and an epitaxial second lower semiconductor body (111) arranged along a second portion (42a) of the second active region (42) directly opposite to the first portion (41a), at a level of the at least one lower semiconductor layer (112) of the second active region (42);
an epitaxial first upper semiconductor body (121) arranged along the first portion (41a), at a level of the at least one upper semiconductor layer (122) of the first active region (41) and spaced apart from the first lower semiconductor body (111), and an epitaxial second upper semiconductor body (121) arranged along the second portion (42a), at a level of the at least one upper semiconductor layer (122) of the second active region (42) and spaced apart from the second lower semiconductor body (111); and
an epitaxial intermediate semiconductor body (22) arranged between the first and second active regions (41, 42), in contact with the first and second lower and upper semiconductor bodies (111, 121) and connecting the first and second lower and upper semiconductor bodies (111, 121),
wherein the lower and upper semiconductor bodies (111, 121) are doped to define relatively high-doped P-type and N-type diode body portions, respectively, of the PIN diode structure (20), and wherein the intermediate semiconductor body (22) defines a relatively low-doped or intrinsic diode portion of the PIN diode structure (20).

2. The semiconductor device according to claim 1, further comprising:
a first bottom diode contact (126) contacting the first lower semiconductor body (111), and/or a second bottom contact (126) contacting the second lower semiconductor body (111); and
a first top diode contact (124) contacting the first upper semiconductor body (121), and/or a second top diode contact (124) contacting the second upper semiconductor body (121).

3. The semiconductor device according to any one of the preceding claims,
wherein the first lower semiconductor body (111) is arranged in contact with the at least one lower semiconductor layer (112) of the first active region (41), and the second lower semiconductor body (111) is arranged in contact with the at least one lower semiconductor layer (112) of the second active region (42); and
wherein the first upper semiconductor body (121) is arranged in contact with the at least one upper semiconductor layer (122) of the first active region (41), and the second upper semiconductor body (121) is arranged in contact with the least one upper semiconductor layer (122) of the second active region (42).

4. The semiconductor device according to any one of the preceding claims, further comprising a gate structure (61) extending transverse to the first and second active regions (41, 42) and overlapping the first and second active regions (41, 42) adjacent the first and second portions (41a, 42a), wherein the PIN diode structure (20) is located adjacent the gate structure (61).

5. The semiconductor device according to claim 4, further comprising:
a plurality of parallel multilayered active regions (4), each comprising at least one lower semiconductor layer and at least one upper semiconductor layer stacked over the at least one lower semiconductor layer;
a plurality of parallel gate structures (6) extending transverse to the plurality of active regions (4) and overlapping respective channel regions of the active regions (4);
a plurality of complementary field-effect transistor, CFET, devices, (10) wherein each CFET device (10) comprises a respective one of the channel regions, and wherein each CFET device (10) comprises a bottom transistor device (11) and a top transistor device (12) stacked on top of the bottom transistor device (11);
wherein the first and second active regions (41, 42) are comprised in the plurality of active regions (4), and wherein the PIN diode structure (20) is located adjacent one of the plurality of gate structures (61).

6. A method for forming a semiconductor device (1), the method comprising:
forming first and second parallel multilayered semiconductor fins (41, 42) on a substrate (101), each comprising at least one lower semiconductor layer (112) and at least one upper semiconductor layer (122) stacked over the at least one lower semiconductor layer (112);
recessing a first portion of the first fin (41a) to form a first recess (41a) in the first fin, and a second portion of the second fin (42) to form a second recess (42a) in the second fin (42), wherein the first and second recesses (41a, 42a) are formed directly opposite each other;
forming a PIN diode structure (20) by:
epitaxially growing a first lower semiconductor body (111) in the first recess (41a), in contact with each lower semiconductor layer (112) of the first fin (41), and a second lower semiconductor body (111) in the second recess (42a), in contact with each lower semiconductor layer (112) of the second fin (42);
epitaxially growing intermediate semiconductor body portions (221, 222) between the first and second fins (41, 42), wherein the intermediate semiconductor body portions (221, 222) are grown from respective sidewall portions of the first and second lower semiconductor bodies (111) such that the intermediate body portions (221, 222) merge between the first and second fins (41, 42) to define a common intermediate semiconductor body (22) connecting the first and second lower semiconductor bodies (111) and having a top surface protruding above a level of the first and second lower semiconductor bodies (112); and
subsequently, epitaxially growing a first upper semiconductor body (121) in the first recess (41a), spaced apart from the first lower semiconductor body (111) and in contact with each upper semiconductor layer (122) of the first fin (41) and the top surface of the intermediate semiconductor body (22), and a second upper semiconductor body (121) in the second recess (42a), spaced apart from the second lower semiconductor body (111) and in contact with each upper semiconductor layer (122) of the second fin (42) and the top surface of the intermediate semiconductor body (22);
wherein the lower and upper semiconductor bodies (111, 121) are doped to define relatively high-doped P-type and N-type diode body portions, respectively, of the PIN diode structure (20), and wherein the intermediate semiconductor body (22) defines a relatively low-doped or intrinsic diode portion of the PIN diode structure (20).

7. A method for forming a semiconductor device, the method comprising:
forming first and second parallel multilayered semiconductor fins (41, 42) on a substrate (101), each comprising at least one lower semiconductor layer (112) and at least one upper semiconductor layer (122) stacked over the at least one lower semiconductor layer (112);
recessing a first portion of the first fin (41a) to form a first recess (41a) in the first fin, and a second portion of the second fin (42) to form a second recess (42a) in the second fin (42), wherein the first and second recesses are formed directly opposite each other;
forming a PIN diode structure (20) by:
epitaxially growing a first lower semiconductor body (111) in the first recess (41a), in contact with each lower semiconductor layer (112) of the first fin (41), and a second lower semiconductor body (111) in the second recess (42a), in contact with each lower semiconductor layer (111) of the second fin (42);
epitaxially growing a first upper semiconductor body (121) in the first recess (41a), spaced apart from the first lower semiconductor body (111) and in contact with each upper semiconductor layer (122) of the first fin (41), and a second upper semiconductor body (121) in the second recess (42a), spaced apart from the second lower semiconductor body (111) and in contact with each upper semiconductor layer (122) of the second fin (42); and
subsequently, epitaxially growing intermediate semiconductor body portions (221a, 221b, 222a, 222b) between the first and second fins (41, 42), wherein the intermediate semiconductor body portions (221a, 221b, 222a, 222b) are grown from respective sidewall portions of the first and second lower and upper semiconductor bodies (111, 121) such that the intermediate body portions (221a, 221b, 222a, 222b) merge between the first and second fins (41, 42) to define a common intermediate semiconductor body (22) connecting the first and second lower and upper semiconductor bodies (111, 121),
wherein the lower and upper semiconductor bodies (111, 121) are doped to define relatively high-doped P-type and N-type diode body portions, respectively, of the PIN diode structure (20), and wherein the intermediate semiconductor body (22) defines a relatively low-doped or intrinsic diode portion of the PIN diode structure (20).

8. The method according to any one of claims 6-7, further comprising:
forming a first bottom diode contact (126) contacting the first lower semiconductor body (111), and/or a second bottom diode contact (126) contacting the second lower semiconductor body (111); and
forming a first top diode contact (124) contacting the first upper semiconductor body (121), and/or a second top diode contact (124) contacting the second upper semiconductor body (121).

9. The method according to any one of claims 6-8, further comprising:
forming a cover layer (14a, 14) covering the first and second lower semiconductor bodies (111); and
forming a trench (200) in the cover layer (14a, 14) between the first and second portions of the first and second fins (41a, 42a),
wherein the intermediate semiconductor body (22) is grown in the trench (200).

10. The method according to claim 9, when dependent on claim 6, wherein the cover layer (14a) is formed such that a top surface of the cover layer (14a) is located at a higher level than the first and second lower semiconductor bodies (111) and at a lower level than each upper semiconductor layer (122), and wherein the trench (200) is formed to expose the respective sidewall portions of the first and second lower semiconductor bodies (111).

11. The method according to claim 10, wherein the cover layer (14a) is used as an epitaxy mask for the first and second lower semiconductor bodies (111) while forming the first and second upper semiconductor bodies (121).

12. The method according to claim 9, when dependent on claim 7, wherein the cover layer (14) is formed to cover the first and second lower and upper semiconductor bodies (111, 121), and wherein the trench (200) is formed to expose the respective sidewall portions of the first and second lower and upper semiconductor bodies (111, 121).

13. The method according to claim 12,
wherein the cover layer (14) comprises a lower portion (14a) formed after forming the first and second lower semiconductor bodies (111) and prior to forming the first and second upper semiconductor bodies (121), and an upper portion (14b) formed on top of the lower portion (14a) after forming the first and second upper semiconductor bodies (121) to cover the same prior to forming the trench (200),
wherein the lower portion (14a) is formed such that its top surface is located at a higher level than the first and second lower semiconductor bodies (111) and at a lower level than each upper semiconductor layer (122), and
wherein the lower portion (14a) is used as an epitaxy mask for the first and second lower semiconductor bodies (111) while forming the first and second upper semiconductor bodies (121).

14. The method according to any one of claims 6-13, further comprising forming a gate structure (61) extending transverse to the first and second fins (41, 42) and overlapping the first and second fins (41, 42) adjacent the first and second portions (41a, 42a), wherein the first and second recesses are formed by vertically etching back the first and second portions of the first and second fins (41, 42) adjacent the gate structure (61).

15. The method according to any one of claims 6-14, wherein the method comprises forming a plurality of parallel multilayered semiconductor fins (4) on the substrate (2), each comprising at least one lower semiconductor layer and at least one upper semiconductor layer stacked over the at least one lower semiconductor layer, and wherein the method further comprises:
forming a plurality of complementary field-effect transistor, CFET, devices (10), wherein each CFET device is formed along a fin of the plurality of fins (4), and each CFET device (10) comprises a bottom transistor device (11) and a top transistor device (12) stacked on top of the bottom transistor device (11), wherein forming the plurality of CFET devices (10) comprises:
forming a plurality of gate structures (6) extending transverse to the plurality of fins (4) and overlapping respective channel regions (4c) of the fins (4);
recessing portions of the fins (4) on either side of the respective channel regions to form a plurality of recesses;
epitaxially growing lower semiconductor bodies in the recesses, in contact with each lower semiconductor layer of the respective fin, the lower semiconductor bodies defining bottom source/drain features of the respective bottom transistor devices of the CFET devices (10); and
epitaxially growing upper semiconductor bodies in the recesses, in contact with each upper semiconductor layer of the respective fin, the upper semiconductor bodies defining top source/drain features of the respective top transistor devices of the CFET devices (10);
wherein the first and second fins (41, 42) are comprised in the plurality of fins (4);
wherein the first and second recesses (41a, 42a) are formed simultaneous to the plurality of recesses, and
wherein the first and second lower semiconductor bodies (111) of the PIN diode structure (20) are formed simultaneous to the bottom source/drain features and the first and second upper semiconductor bodies (121) of the PIN diode structure (20) are formed simultaneous to the top source/drain features.
